# FASCICULE DE BREVET EUROPEEN

(11) **EP 3 005 409 B1**
(45) Date de publication et mention de la délivrance du brevet: **20.04.2022**
(21) Numéro de dépôt: 14733236.5
(22) Date de dépôt: 02.06.2014
(51) Int. Cl.: H01L 21/50, H01L 33/00

(54) **PROCÉDÉ DE COLLAGE MÉTALLIQUE DIRECT**
VERFAHREN ZUM DIREKTEN METALLBONDEN
METHOD FOR DIRECT METAL BONDING

(30) Priorité: 03.06.2013 FR 1355043
(43) Date de publication de la demande: 13.04.2016
(73) Titulaire: Commissariat à l'Énergie Atomique et aux Énergies Alternatives, 75015 Paris (FR)
(72) Inventeur: BAUDIN, Floriane, F-38000 Grenoble (FR); DI CIOCCIO, Léa, F-38330 Saint Ismier (FR)
(74) Mandataire: Germain Maureau
(86) Numéro de dépôt international: PCT/FR2014/051306
(87) Numéro de publication internationale: WO 2014/195621

(56) Documents cités:
- WO-A1-2012/062613
- US-A1- 2010 170 936
- US-A1- 2010 171 195
- US-A1- 2011 298 083

## Description

La présente invention concerne un procédé de collage métallique direct, notamment pour des applications dans le domaine photovoltaïque, de l'intégration tridimensionnelle, dans la fabrication de MEMS (pour microsystème électromécanique), et de LEDs (pour Light Emitting Diodes).

La présente invention concerne en outre une structure comprenant un collage métallique direct entre deux substrats de matériaux semi-conducteurs.

Dans cette description, par collage métallique direct on entend le collage de deux couches de métal directement l'une sur l'autre et notamment sans interposition de matière adhésive.

Un procédé de collage métallique direct connu du déposant met en œuvre un collage direct de deux couches métalliques sous atmosphère ambiante. En conséquence, un oxyde natif se forme à la surface des couches métalliques avant la mise en contact, ce qui détériore la qualité du collage. Les énergies de collage (exprimées en J/m²) obtenues avec cette technique ne deviennent compatibles avec les procédés ultérieurs souhaités (Smart Cut, amincissement mécanique) que pour des hautes températures de recuit de collage, par exemple au-delà de 800°C pour le tungstène. Or, ces températures ne sont pas compatibles avec les procédés de fabrication de circuits intégrés tel que le BEOL (acronyme anglais de Back-End Of Line).

Afin de pallier cet inconvénient, il a été proposé d'effectuer le collage avec une étape de thermocompression. Un tel procédé est décrit dans WO 2012/062613 A1. Ce procédé permet d'obtenir des collages de bonne qualité mais les rendements sont faibles.

Une autre méthode connue prévoit une étape d'activation des surfaces des couches métalliques sous vide. Mais les coûts de mise en œuvre de ce procédé sont rédhibitoires.

Le problème technique résolu par l'invention est de fournir un procédé de collage métallique direct de qualité satisfaisante tout en présentant un coût de revient réduit.

A cet effet, la présente invention propose un procédé de collage métallique direct comprenant les étapes suivantes :
a) Fournir un premier empilement comprenant un premier substrat sur lequel est déposée une première couche métallique comprenant un premier métal, et une première couche de solubilisation distincte de la première couche métallique, la première couche de solubilisation comportant un premier matériau getter configuré pour solubiliser de l'oxygène,
b) Fournir un second empilement comprenant un second substrat sur lequel est déposée une seconde couche métallique comprenant un second métal,
c) Mettre en contact la première couche métallique et la seconde couche métallique de sorte à obtenir un collage métallique direct entre la première couche métallique et la seconde couche métallique, et
d) Appliquer un traitement thermique de recuit du collage,
e) Application d'un traitement thermique d'activation configuré pour solubiliser de l'oxygène, de sorte à obtenir une structure comprenant le premier substrat, la première couche de solubilisation, la première couche métallique collée par collage métallique direct à la seconde couche métallique, et le second substrat.

L'expression « matériau getter, ou matériau getter configuré pour solubiliser de l'oxygène, ou matériau permettant la solubilisation de l'oxygène » s'entend dans le présent document comme un matériau comportant des propriétés absorbantes et/ou adsorbantes vis-à-vis de molécules gazeuses, pouvant ainsi réaliser une pompe de gaz chimique, notamment de l'oxygène. De telles propriétés peuvent être obtenues par la composition moléculaire du matériau et/ou de sa structure microscopique ou nanoscopique. Ces matériaux sont par exemple des métaux, tels que du titane, du zirconium, de l'hafnium, ou encore des alliages métalliques de ces métaux ou d'autres métaux adaptés. Les propriétés d'adsorption de l'oxygène des matériaux getters sont spécifiques du matériau considéré, par exemple le titane permet d'adsorber environ 33% atomique d'oxygène, le hafnium et le zirconium environ 20% atomique.

Par l'expression 'traitement thermique de recuit du collage' on entend dans le présent document un traitement thermique permettant le renforcement du collage direct entre la première couche métallique et la seconde couche métallique obtenu à l'étape c) de sorte à obtenir une forte énergie de collage.

Il est également compris dans le présent document que, lorsqu'une première couche est déposée sur un substrat ou sur une seconde couche, la première couche peut être déposée directement ou indirectement sur le substrat ou sur la seconde couche. Ainsi, il est envisageable qu'une ou plusieurs couches intermédiaires puissent être intercalées entre la première couche et le substrat ou la première couche et la seconde couche.

Le procédé selon l'invention, permet de coller une première et une seconde couche métallique directement l'une sur l'autre de façon à assurer une conduction électrique dans une direction normale à la première et seconde couche. Un tel type de conduction électrique est également appelée conduction verticale.

En outre, les première et seconde couches métalliques sont collées de façon thermiquement stable, c'est-à-dire sans apparition de bulles à l'interface de collage ou de décollement même lors de traitements thermiques.

De plus, l'énergie nécessaire pour séparer la première et la seconde couche métallique appelée énergie de collage est accrue.

L'oxyde natif, formé à l'air sous atmosphère ambiante sur les couches métalliques avant leur mise en contact, se retrouve encapsulé à l'interface de collage ce qui empêche d'atteindre une énergie de collage élevée entre les métaux.

Toutefois, la couche de solubilisation adaptée pour solubiliser des molécules gazeuses de l'atmosphère environnante permet également de capter l'oxygène provenant de l'oxyde natif sur les couches métalliques en contact avec la couche de solubilisation.

La couche de solubilisation favorise ainsi le processus de collage métallique direct en favorisant la diffusion de l'oxygène à travers le métal jusqu'au matériau getter, à partir d'une certaine température. Lorsqu'il n'y a plus d'oxyde, les deux métaux sont en contact intime, ce qui permet une interdiffusion.

Ainsi, le procédé selon l'invention permet un collage métallique direct de qualité sans passer par un procédé sous vide, ni d'étape de thermocompression ni de traitement thermique de recuit de collage à température élevée, et avantageusement sans recuit à une température supérieure à la température d'activation du matériau getter.

Par ailleurs, cette forte énergie de collage permet de réaliser par la suite des opérations d'amincissement mécanique ou autres étapes générant des contraintes sur l'assemblage, effectuées notamment pour la fabrication de dispositifs électroniques.

Selon une possibilité, l'étape d) est réalisée sous une pression inférieure ou égale à environ 0.1MPa, appliquée de part et d'autre des premier et deuxième empilements collés. Cette pression est notamment la pression maximale applicable par le stylet utilisé pour le collage.

Il est ainsi possible de réaliser le collage métallique avec une énergie de collage de plus de 2J/m² sans utiliser d'étape thermocompressive, cette dernière nécessitant l'application d'une pression d'au minimum 0.2MPa et généralement une pression comprise entre 5 et 10MPa selon la température utilisée.

Le procédé selon l'invention comprend une étape e) comprenant l'application d'un traitement thermique d'activation configuré pour solubiliser de l'oxygène. Ainsi, le traitement thermique d'activation permet d'activer le premier matériau getter qui est alors configuré pour solubiliser de l'oxygène provenant notamment de l'oxyde natif formé sur les couches métalliques.

Selon une variante de réalisation, l'étape e) est réalisée au moins en partie par l'étape d). Ainsi, l'activation du matériau getter est obtenue après le collage métallique direct entre la première et la seconde couche métallique.

Selon une possibilité, l'étape e) est réalisée au moins en partie avant l'étape c) de mise en contact. Ainsi l'activation du matériau getter est obtenue avant le collage métallique direct entre la première et la seconde couche métallique.

De préférence, le procédé comprend avant l'étape a) une étape j) consistant à déposer la première couche métallique selon des conditions de dépôt favorisant la présence de joints de grains.

De préférence encore, le procédé comprend avant l'étape b), une étape jj) consistant à déposer la seconde couche métallique selon des conditions de dépôt favorisant la présence de joints de grains.

La présence de joints de grains augmente en effet la capacité des couches métalliques à diffuser de l'oxygène jusqu'à la couche de solubilisation. Plus les joints de grains sont nombreux et plus la diffusion de l'oxygène est importante.

De préférence, le procédé comprend avant l'étape a) une étape j) consistant à déposer la première couche métallique selon une structure au moins en partie de type colonnaire.

De préférence encore, le procédé comprend avant l'étape b), une étape jj) consistant à déposer la deuxième couche métallique selon une structure au moins en partie de type colonnaire.

La structure colonnaire des première et seconde couches métalliques, c'est-à-dire une structure comportant des joints de grains métalliques perpendiculaires à la surface des couches, favorise en effet la diffusion de l'oxygène à partir de l'oxyde natif vers la matrice de la couche de solubilisation dans laquelle l'oxygène peut se solubiliser.

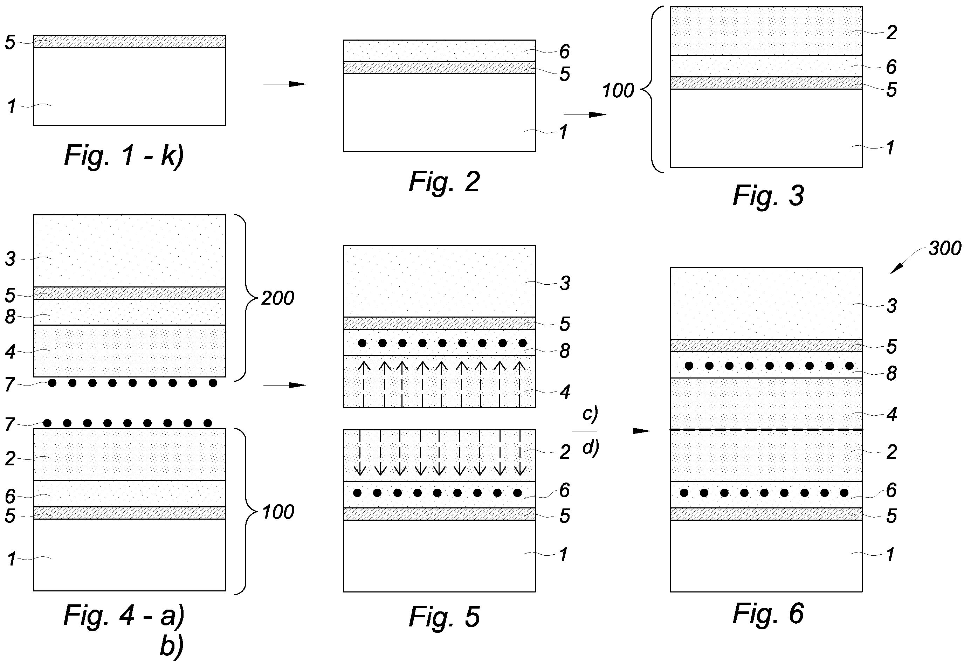

Une méthode de dépôt utilisée pour l'obtention de structures colonnaires est par exemple la CVD (dépôt chimique en phase vapeur) ou la PVD (dépôt physique en phase vapeur) notamment mise en oeuvre par pulvérisation cathodique ou par évaporation. Les conditions de dépôts par PVD sont par exemple décrites dans A. Thornton, « High Rate Thick Film Growth », Annual Review of Materials Science, vol. 7, no 1, p. 239-260, 1977. Pour l'obtention d'une structure colonnaire, les conditions conduisant à la formation des zones 1, T et 2 du diagramme de Thornton sont par exemple à privilégier (figure 1b par exemple). En effet, elles conduisent à la formation de nombreux joints de grains favorables à la diffusion de l'oxygène. Ainsi, si l'on considère que T est la température du substrat et Tm la température de fusion de la couche métallique, le dépôt est avantageusement réalisé avec un rapport T/Tm compris entre 0.1 et 0.5 et une pression partielle d'argon de 1 à 30 mTorr.

De plus, les première et seconde couches métalliques sont déposées de sorte à présenter des grains de petites tailles. Ceci peut être obtenu notamment en évitant la recristallisation et la croissance de grains dans les couches métalliques déposées. Les joints de grains favorisant la diffusion de l'oxygène sont ainsi plus nombreux, ce qui participe à la formation d'un grand nombre de vides intracolonnaire favorables à la diffusion gazeuse.

Selon une disposition particulière, les première et seconde couches métalliques sont déposées sur une épaisseur comprise entre environ 5 nanomètres et 5 micromètres. Cette épaisseur rend ainsi possible des opérations de planarisation de la surface si besoin, par exemple par CMP consommatrice de matériau, avant de procéder au collage.

De préférence, la surface exposée des première et seconde couches métalliques est préparée au collage direct, notamment jusqu'à atteindre une rugosité de 0.7 nanomètre RMS. Ces valeurs RMS sont déterminées par microscopie à force atomique AFM sur un champ de 20x20 micromètres.

Selon une disposition, ledit second empilement comprend en outre une seconde couche de solubilisation distincte de la seconde couche métallique, la seconde couche de solubilisation comportant un second matériau getter configuré pour solubiliser de l'oxygène. La présence d'une seconde couche de solubilisation favorise une bonne capture de l'oxygène provenant de l'oxyde natif de l'une ou des deux couches métalliques.

Selon une possibilité, le premier matériau getter permettant la solubilisation de l'oxygène comprend un alliage du premier métal et du premier matériau getter et/ou le second matériau permettant la solubilisation de l'oxygène comprend un alliage du second métal et du second matériau getter. L'alliage permet d'obtenir une interface mécaniquement résistante entre la couche de solubilisation et la couche métallique.

De préférence, l'étape j) comporte une étape de dépôt de la première couche de solubilisation sur le premier substrat avant le dépôt de la première couche métallique. Ainsi, la première la couche métallique est déposée directement sur la première couche de solubilisation ce qui permet de limiter la distance entre l'oxyde natif et le matériau getter permettant la solubilisation de l'oxygène, favorisant ainsi la capture de l'oxygène.

Avantageusement, l'étape jj) comporte une étape de dépôt de la seconde couche de solubilisation sur le second substrat avant le dépôt de la seconde couche métallique. Ceci favorise également la capture de l'oxygène provenant de l'oxyde natif du second métal.

Il est à noter que la distance pour laquelle le matériau getter permet la solubilisation de l'oxygène dépend des propriétés de la couche métallique déposée, (solubilité de l'oxygène dans le métal, nombre et taille des joints de grains, importance de la structure colonnaire) et du budget thermique utilisé, qui favorisent de façon plus ou moins importante la diffusion de l'oxygène vers le matériau getter. Par exemple, pour une couche métallique de tungstène de structure colonnaire et l'utilisation d'une couche de solubilisation de Ti, une solubilisation efficace est observée avec une épaisseur de couche de tungstène de l'ordre du micromètre.

Selon une alternative, la première couche de solubilisation est enterrée au sein de la première couche métallique et/ou la seconde couche de solubilisation est enterrée au sein de la seconde couche métallique. Cette alternative permet de conserver une épaisseur de couche métallique optimale pour planarisation de la surface tout en réduisant la distance entre l'oxyde natif et le matériau getter permettant la solubilisation de l'oxygène.

Selon une possibilité, l'étape a) comprend l'application d'un traitement thermique d'activation selon l'étape e), réalisée sous atmosphère inerte, de manière à activer ledit premier matériau getter permettant la solubilisation de l'oxygène.

Selon une autre possibilité, l'étape b) comprend l'application d'un traitement thermique d'activation selon l'étape e), réalisée sous atmosphère inerte, de manière à activer ledit second matériau getter configuré pour solubiliser de l'oxygène.

Ainsi, une fois le premier et /ou le second matériau getter permettant la solubilisation de l'oxygène activé à la température d'activation spécifique du matériau considéré, ce dernier est apte à capter des espèces gazeuses. Les première et deuxième couches métalliques peuvent ensuite être mises en contact pour un collage à chaud. L'oxygène provenant de l'oxyde natif peut diffuser à travers les joints de grains jusqu'à être solubilisé dans les couches de solubilisation. La température du traitement thermique d'activation de l'étape e) est variable selon la nature du matériau getter permettant la solubilisation de l'oxygène utilisé.

Selon une variante, l'étape a) et/ou l'étape b) comprend l'application d'un traitement thermique d'activation selon l'étape e), réalisée sous ultra vide, telle qu'une pression inférieure à 10⁻⁵ mbar, de manière à activer au moins ledit premier matériau getter permettant la solubilisation de l'oxygène. Ces conditions permettent une activation plus rapide ou l'utilisation d'une température plus basse que lors d'un traitement d'activation sous pression atmosphérique.

De préférence, les première et seconde couches de solubilisation sont déposées par PVD (dépôt physique en phase vapeur) tel que par pulvérisation cathodique ou évaporation.

Selon une disposition, les première et seconde couches de solubilisation sont déposées sur une épaisseur comprise environ entre 2 et 500 nanomètres.

Selon encore une variante de réalisation, la première couche de solubilisation et/ou la seconde couche de solubilisation est constituée par une pluralité de couches de solubilisation élémentaires, de compositions différentes.

Selon une autre disposition, les première et deuxième couches métalliques sont collées à froid, auquel cas, le traitement thermique de l'étape d) de renforcement du collage est également utilisée pour réaliser au moins en partie l'étape e) et activer le premier matériau getter permettant la solubilisation de l'oxygène et/ou le second matériau getter permettant la solubilisation de l'oxygène. Par l'expression « collées à froid » on entend dans le présent document « collées à température ambiante ». Le collage à froid diffère du « collage à chaud » pour lequel les empilements sont chauffés (au-dessus de la température ambiante) avant de procéder à la mise en contact.

Avantageusement, l'application du traitement thermique de l'étape d) est effectuée à une température inférieure ou égale à 600°C et de préférence à une température inférieure ou égale à 400°C, l'énergie de collage entre la première couche métallique et la seconde couche métallique atteignant une valeur supérieure ou égale à 1J/m² et de préférence supérieure ou égale à 2J/m². Ainsi, grâce à la présence de la première couche de solubilisation et /ou de la deuxième couche de solubilisation, l'énergie de collage atteinte entre le premier substrat et le second substrat permet la réalisation d'étapes de procédés engendrant des contraintes de nature à affaiblir le collage, tel qu'un amincissement mécanique, un transfert de couche par Smart Cut^{™}.

De plus, ce procédé permet de réduire la température du recuit de collage à une température compatible avec les procédés BEOF.

De préférence, la première couche de solubilisation et/ou la seconde couche de solubilisation sont configurés pour présenter une capacité de solubilisation de l'oxygène supérieure ou égale à 20 % atomique.

Le premier et/ou le deuxième matériau getter permettant la solubilisation de l'oxygène sont choisis parmi le titane, le zirconium, le palladium, le hafnium, et les alliages métalliques de ces métaux.

Les couches de solubilisation présentent une épaisseur choisie pour absorber l'oxygène présent. A titre d'exemple, 15 nm de Ti sont nécessaires pour absorber l'oxygène contenu dans 3 nm de couche d'oxyde.

Selon une possibilité, le premier et/ou le deuxième matériau getter sont choisis parmi le titane, le zirconium, le palladium, le hafnium, le vanadium et les alliages métalliques de ces métaux.

Avantageusement, le premier métal et le second métal sont choisi parmi le Ti, Al, Au, Ag, Cu, Co, Ni, Pt, Fe, Cr, Ru, Mo, Ta, Nb, Re, W et les alliages métalliques de ces métaux.

Il est entendu que le procédé est d'autant plus efficace que le premier métal et/ou le second métal présente une faible solubilité de l'oxygène. C'est notamment le cas du W pour lequel la solubilité de l'oxygène est inférieure à 1% atomique.

Egalement, le matériau getter ou l'alliage du matériau getter et du métal de la première couche et/ou de la deuxième couche de solubilisation est choisi de sorte à présenter une capacité de solubilisation de l'oxygène plus importante que celle respectivement du métal de la première couche métallique et/ou de la seconde couche métallique.

Selon une possibilité, l'étape a) et/ou l'étape b) comprend une étape k) comportant le dépôt d'une couche barrière formant une barrière de diffusion de matériaux contaminants directement sur le premier substrat et/ou directement sur le second substrat, la couche barrière comprenant notamment un matériau choisi parmi le TiN, WN, TaN.

Avantageusement, le premier substrat et/ou le second substrat est constitué d'un matériau semi-conducteur. La structure obtenue à l'issu du procédé de l'invention peut ainsi être utilisée dans le domaine de l'intégration 3D, dans le domaine photovoltaïque pour la fabrication de MEMS, ou des LEDs.

Selon une possibilité, le premier substrat et/ou le second substrat est constitué d'un matériau massif.

Selon une possibilité, le procédé comprend après l'étape d) une étape de réalisation d'au moins un dispositif microélectronique ou nanoélectronique sur le premier substrat et/ou sur le second substrat de matériau semi-conducteur.

Les premier et second substrats peuvent être composés du même matériau semi-conducteur comme de matériaux semi-conducteur différents.

Le premier métal et le second métal utilisés peuvent être différents ou identiques.

De même, le premier et le second matériau getter peuvent être différents ou identiques.

L'invention propose également une structure comprenant une interface de collage direct métallique pour des applications dans le domaine de l'intégration 3D, la structure comportant successivement de sa base vers sa surface un premier substrat d'un premier matériau semi-conducteur, une première couche de solubilisation comportant un premier matériau getter configuré pour solubiliser de l'oxygène, une première couche métallique d'un premier métal, distincte de la première couche de solubilisation et collée par collage métallique direct à une seconde couche métallique d'un second métal, la seconde couche métallique, une seconde couche de solubilisation distincte de la seconde couche métallique, comportant un second matériau getter configuré pour solubiliser de l'oxygène et un second substrat d'un second matériau semi-conducteur.

D'autres aspects, buts et avantages de la présente invention apparaîtront mieux à la lecture de la description suivante de modes de réalisation de celle-ci, donnée à titre d'exemples non limitatifs et faite en référence aux dessins annexés. Les figures ne respectent pas nécessairement l'échelle de tous les éléments représentés de sorte à améliorer leur lisibilité. Dans la suite de la description, par souci de simplification, des éléments identiques, similaires ou équivalents des différentes formes de réalisation portent les mêmes références numériques.
- Les figures 1 à 6 illustrent un schéma de principe du procédé selon un mode de réalisation de l'invention.
- Les figures 7 à 12 illustrent un schéma de principe du procédé selon une alternative de réalisation selon l'invention.

Comme illustré aux figures 1 à 6, le procédé de collage direct métallique est mis en œuvre à partir d'un premier empilement 100 comportant un premier substrat 1 recouvert par une première couche métallique 2 et d'un second empilement 200 comportant un second substrat 3 recouvert par une seconde couche métallique 4.

Le premier substrat 1 constitué d'un matériau massif de silicium est tout d'abord protégé, si nécessaire, par le dépôt d'une couche barrière 5 en TiN par exemple, permettant d'éviter les contaminations de matériaux pouvant survenir au cours des étapes ultérieures (figure 1). Puis une première couche de solubilisation 6 en titane est déposée par PVD sur la surface de la couche barrière 5 avec une épaisseur d'environ 100 nanomètres (figure 2). La première couche de solubilisation 6 est ensuite recouverte par une première couche métallique 2 de tungstène déposée par CVD de sorte à obtenir un matériau de structure colonnaire comportant de nombreux joints de grains (figure 3). L'épaisseur de la première couche métallique 2 atteint 500 nanomètres environ. A l'issu du dépôt, la surface de la première couche métallique 2 est ensuite préparée au collage jusqu'à atteindre une rugosité adaptée au collage direct, i.e. une rugosité inférieure à 0,7 nm RMS mesurée sur un champ de 20x20 micromètres. Après préparation, son épaisseur est d'environ un 250 nanomètres. La manipulation sous atmosphère ambiante du premier empilement 100 ainsi obtenu, génère l'oxydation de la première couche 2 de tungstène avec l'humidité contenue dans l'air, ce qui crée un oxyde natif 7 en surface (figure 4).

En parallèle, le second empilement 200 est préparé pour le collage métallique direct avec le premier empilement 100. Une couche barrière 5 de TiN suivie d'une seconde couche de solubilisation 8 de titane puis d'une seconde couche métallique 4 de tungstène sont déposées en surface d'un second substrat 3 de silicium. La surface exposée de la seconde couche métallique 4 est préparée pour un collage direct (figure 4). Un oxyde natif 7 est généré à l'air libre sur la surface à coller, de la même façon que sur le premier empilement 100.

Un traitement thermique d'activation du matériau getter permettant la solubilisation de l'oxygène est alors appliqué à 400°C de sorte à pouvoir solubiliser l'oxygène provenant de l'oxyde métallique natif 7 des première et deuxième couches métalliques 2,4 (étape e). L'oxygène de l'oxyde natif 7 diffuse à travers les joints de grains des première et deuxième couches métalliques 2,4 pour venir se solubiliser dans les première et seconde couches de solubilisation 6,8 (figure 5).

Puis, selon l'étape c) du procédé, les surfaces des première et deuxième couches métalliques 2,4 sont mises en contact pour un collage à chaud sans nouveau contact avec l'air, de sorte à éviter la génération d'un nouvel oxyde natif 7 (figure 6). Selon l'étape d), un traitement thermique de recuit du collage finalise l'assemblage de la structure 300 ainsi formée. La démixtion de l'oxygène provenant des oxydes natifs 7 permet un contact métal-métal à l'interface de collage de sorte qu'une forte énergie de collage est obtenue.

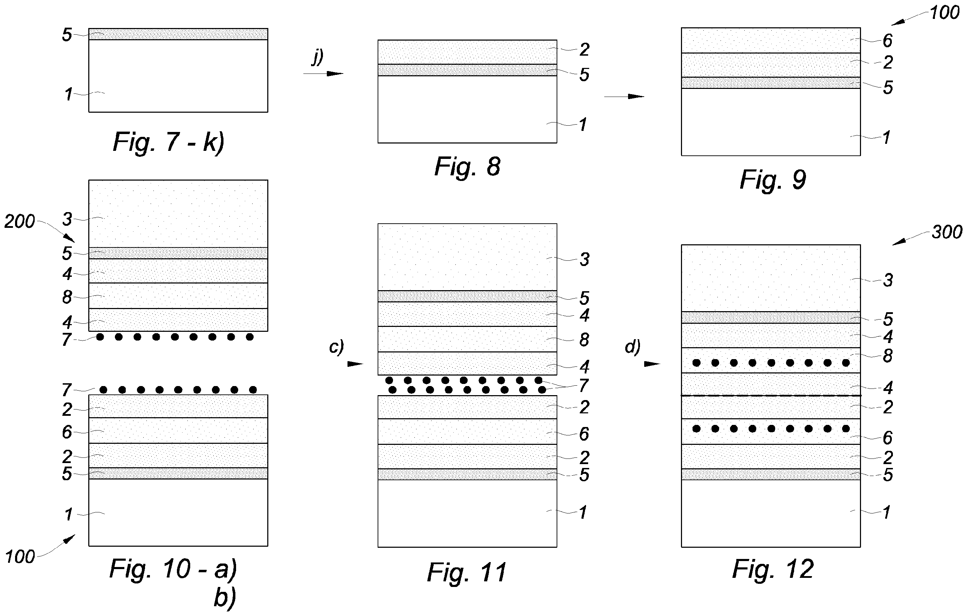

Selon une variante de réalisation de l'invention décrite aux figures 7 à 12, le procédé de l'invention comprend la fourniture d'un premier empilement 100 comportant un premier substrat 1 de silicium recouvert d'une couche barrière 5 de Ti. Une première couche métallique 2 de cuivre déposée sur la couche barrière 5 comprend en son sein une première couche de solubilisation 6 de Zr enterrée (étape a) figure 7 à 9).

De façon similaire, le procédé comprend la fourniture d'un second empilement 200 comportant un second substrat 3 de silicium recouvert d'une couche barrière 5 de Ti sur laquelle a été déposée une seconde couche métallique 4 de cuivre dans laquelle est enterrée une seconde couche de solubilisation 8 de Zr (étape b) figure 10). Les premier et second empilements 100,200 comportent chacun un oxyde natif 7 formé sous atmosphère ambiante en surface des première et seconde couches métalliques 2,4.

Les premier et second empilements 100,200 sont ensuite mis en contact de sorte à obtenir un collage métallique direct entre la première et la seconde couche métallique 2,4 (étape c) figure 11) et former une structure assemblée 300. Puis selon l'étape d) du procédé, un traitement thermique de recuit du collage est appliqué à une température inférieure à 600°C de sorte à activer le matériau getter selon l'étape e) du procédé permettant la solubilisation de l'oxygène, permettre la capture de l'oxygène provenant du l'oxyde natif 7 et atteindre une énergie de collage supérieure à 2J/m².

Selon une possibilité, une couche d'accroché, notamment en SiO2 peut être prévue entre le matériau semi-conducteur des substrats 1,3 et la couche métallique 2,4 pour assurer une bonne tenue mécanique entre les deux matériaux.

Selon une variante, une seule couche de solubilisation 6,8 est utilisée pour adsorber l'oxygène de l'oxyde natif 7 lors du collage direct.

Par ailleurs, l'invention s'applique également à des premier et second substrats 1,3 choisi parmi des matériaux semi-conducteurs, les premières et secondes couches métalliques 2,4 peuvent en tout métal s'oxydant naturellement à l'air tel que le Ti, Al, Au, Ag, Cu, Co, Ni, Pt, Fe, Cr, Ru, Mo, Ta, Nb, Re, W et les alliages métalliques de ces métaux, de préférence déposé sous forme colonnaire. Les matériaux getter sont choisis parmi le titane, le zirconium, le palladium, le hafnium, le vanadium et les alliages métalliques de ces métaux.

Ainsi, la présente invention propose un procédé de collage direct métallique réalisant un traitement thermique à basse température tout en obtenant une énergie de collage compatible avec des étapes de procédés BEOF et ne devant pas excéder une certaine température de procédé. Ce procédé est simple à mettre en œuvre, applicable à de nombreux matériaux et est peu coûteux. Il conduit à des structures 300 assemblées possédant une conduction verticale et une résistance mécanique à l'amincissement après collage.

Il va de soi que l'invention n'est pas limitée au mode de réalisation décrit ci-dessus à titre d'exemple. La portée de l'invention est définie par les revendications annexées.

## Revendications

1. Procédé de collage métallique direct comprenant les étapes suivantes :
a) Fournir un premier empilement (100) comprenant un premier substrat (1) sur lequel est déposée une première couche métallique (2) comprenant un premier métal, et une première couche de solubilisation (6) distincte de la première couche métallique (2), la première couche de solubilisation (6) comportant un premier matériau getter configuré pour solubiliser de l'oxygène,
b) Fournir un second empilement (200) comprenant un second substrat (3) sur lequel est déposée une seconde couche métallique (4) comprenant un second métal,
c) Mettre en contact la première couche métallique (2) et la seconde couche métallique (4) de sorte à obtenir un collage métallique direct entre la première couche métallique (2) et la seconde couche métallique (4), et
d) Appliquer un traitement thermique de recuit du collage,
e) Application d'un traitement thermique d'activation configuré pour solubiliser de l'oxygène,
**caractérisé en ce qu'**une structure (300) comprenant le premier substrat (1), la première couche de solubilisation (6), la première couche métallique (2) collée par collage métallique direct à la seconde couche métallique (4), et le second substrat (3) est obtenue.

2. Procédé selon la revendication 1, **caractérisé en ce que** l'étape e) est réalisée au moins en partie par l'étape d).

3. Procédé selon la revendication 1 ou 2, **caractérisé en ce que** l'étape e) est réalisée au moins en partie avant l'étape c) de mise en contact.

4. Procédé selon l'une des revendications 1 à 3, **caractérisé en ce que** le procédé comprend avant l'étape a) une étape j) consistant à déposer la première couche métallique (2) selon des conditions de dépôt favorisant la présence de joints de grains et/ou **en ce que** le procédé comprend avant l'étape b), une étape jj) consistant à déposer la seconde couche métallique (4) selon des conditions de dépôt favorisant la présence de joints de grains.

5. Procédé selon l'une des revendications 1 à 4, **caractérisé en ce que** le procédé comprend avant l'étape a) une étape j) consistant à déposer la première couche métallique (2) selon une structure au moins en partie de type colonnaire et/ou **en ce que** le procédé comprend avant l'étape b), une étape jj) consistant à déposer la seconde couche métallique (4) selon une structure au moins en partie de type colonnaire.

6. Procédé selon l'une des revendications 1 à 5, **caractérisé en ce que** ledit second empilement (200) comprend en outre une seconde couche de solubilisation (8) distincte de la seconde couche métallique (4), la seconde couche de solubilisation (8) comportant un second matériau getter configuré pour solubiliser de l'oxygène.

7. Procédé selon l'une des revendications 1 à 6, **caractérisé en ce que** la première couche de solubilisation (6) comprend un alliage du premier métal et du premier matériau getter et/ou **en ce que** la seconde couche de solubilisation (8) comprend un alliage du second métal et du second matériau getter.

8. Procédé selon l'une des revendications 4 à 7, **caractérisé en ce que** l'étape j) comporte une étape de dépôt de la première couche de solubilisation (6) sur le premier substrat (1) avant le dépôt de la première couche métallique (2) et/ou **en ce que** l'étape jj) comporte une étape de dépôt de la seconde couche de solubilisation (8) sur le second substrat (3) avant le dépôt de la seconde couche métallique (4).

9. Procédé selon l'une des revendications 1 à 6, **caractérisé en ce que** la première couche de solubilisation (6) est enterrée au sein de la première couche métallique (2) et/ou la seconde couche de solubilisation (8) est enterrée au sein de la seconde couche métallique (4).

10. Procédé selon l'une des revendications 1 à 9, **caractérisé en ce que** l'étape a) comprend l'application d'un traitement thermique d'activation sous atmosphère inerte, de manière à activer ledit premier matériau getter permettant la solubilisation de l'oxygène et/ou **en ce que** l'étape b) comprend l'application d'un traitement thermique d'activation sous atmosphère inerte, de manière à activer ledit second matériau getter permettant la solubilisation de l'oxygène.

11. Procédé selon l'une des revendications 1 à 7, **caractérisé en ce que** l'application du traitement thermique de l'étape d) est effectuée à une température inférieure ou égale à 600°C et de préférence à une température inférieure ou égale à 400°C, et **en ce que** l'énergie de collage entre la première couche métallique (2) et la seconde couche métallique (4) atteint une valeur supérieure ou égale à 1J/m² et de préférence supérieure ou égale à 2J/m².

12. Procédé selon l'une des revendications 1 à 11, **caractérisé en ce que** la première couche de solubilisation (6) et/ou la seconde couche de solubilisation (8) sont configurées pour présenter une capacité de solubilisation de l'oxygène supérieure ou égale à 20 % atomique.

13. Procédé selon l'une des revendications 1 à 12 combiné à la revendication 2, **caractérisé en ce que** le premier et/ou le deuxième matériau getter configurés pour solubiliser de l'oxygène sont choisis parmi le titane, le zirconium, le palladium, le hafnium, le vanadium et les alliages métalliques de ces métaux.

14. Structure (300) comprenant une interface de collage direct métallique pour des applications dans le domaine de l'intégration 3D, la structure comportant successivement de sa base vers sa surface un premier substrat (1) d'un premier matériau semi-conducteur, une première couche de solubilisation (6) comportant un premier matériau getter configuré pour solubiliser de l'oxygène, une première couche métallique (2) d'un premier métal, distincte de la première couche de solubilisation (6) et collée par collage métallique direct à une seconde couche métallique (4) d'un second métal, la seconde couche métallique (4), une seconde couche de solubilisation (8) distincte de la seconde couche métallique (4), comportant un second matériau getter configuré pour solubiliser de l'oxygène et un second substrat (3) d'un second matériau semi-conducteur.

## Patentansprüche

1. Verfahren zum direkten Metallbonden, das die folgenden Schritte umfasst:
a) Bereitstellen eines ersten Stapels (100), umfassend ein erstes Substrat (1), auf dem eine erste Metallschicht (2) abgelagert ist, die ein erstes Metall umfasst, und eine erste Solubilisierungsschicht (6), die von der ersten Metallschicht (2) verschieden ist, wobei die erste Solubilisierungsschicht (6) ein erstes Gettermaterial aufweist, das ausgelegt ist, um Sauerstoff zu solubilisieren,
b) Bereitstellen eines zweiten Stapels (200), umfassend ein zweites Substrat (3), auf dem eine zweite Metallschicht (4) abgelagert ist, die ein zweites Metall umfasst,
c) Inkontaktversetzen der ersten Metallschicht (2) und der zweiten Metallschicht (4), so dass ein direktes Metallbonden zwischen der ersten Metallschicht (2) und der zweiten Metallschicht (4) erhalten wird, und
d) Anwenden einer thermischen Temperbehandlung des Bondings,
e) Anwenden einer thermischen Aktivierungsbehandlung, die ausgelegt ist, um Sauerstoff zu solubilisieren,
**dadurch gekennzeichnet, dass** eine Struktur (300) erhalten wird, die das erste Substrat (1), die erste Solubilisierungsschicht (6), die erste Metallschicht (2), die durch direktes Metallbonden auf der zweiten Metallschicht (4) gebondet ist, und das zweite Substrat (3) umfasst.

2. Verfahren nach Anspruch 1, **dadurch gekennzeichnet, dass** der Schritt e) mindestens zum Teil anhand des Schritts d) durchgeführt wird.

3. Verfahren nach Anspruch 1 oder 2, **dadurch gekennzeichnet, dass** der Schritt e) mindestens zum Teil vor dem Schritt c) des Inkontaktversetzens durchgeführt wird.

4. Verfahren nach einem der Ansprüche 1 bis 3, **dadurch gekennzeichnet, dass** das Verfahren vor dem Schritt a) einen Schritt j) umfasst, der darin besteht, die erste Metallschicht (2) gemäß Ablagerungsbedingungen abzulagern, die das Vorhandensein von Korngrenzen fördern und/oder dass das Verfahren vor dem Schritt b) einen Schritt jj) umfasst, der darin besteht, die zweiten Metallschicht (4) gemäß Ablagerungsbedingungen abzulagern, die das Vorhandensein von Korngrenzen fördern.

5. Verfahren nach einem der Ansprüche 1 bis 4, **dadurch gekennzeichnet, dass** das Verfahren vor dem Schritt a) einen Schritt j) umfasst, der darin besteht, die erste Metallschicht (2) gemäß einer Struktur abzulagern, die mindestens zum Teil säulenartig ist und/oder dass das Verfahren vor dem Schritt b) einen Schritt jj) umfasst, der darin besteht, die zweite Metallschicht (4) gemäß einer Struktur abzulagern, die mindestens zum Teil säulenartig ist.

6. Verfahren nach einem der Ansprüche 1 bis 5, **dadurch gekennzeichnet, dass** der zweite Stapel (200) ferner eine zweite Solubilisierungsschicht (8) umfasst, die von der zweiten Metallschicht (4) verschieden ist, wobei die zweite Solubilisierungsschicht (8) ein zweites Gettermaterial aufweist, das ausgelegt ist, um Sauerstoff zu solubilisieren.

7. Verfahren nach einem der Ansprüche 1 bis 6, **dadurch gekennzeichnet, dass** die erste Solubilisierungsschicht (6) eine Legierung des ersten Metalls und des ersten Gettermaterials umfasst und/oder dass die zweite Solubilisierungsschicht (8) eine Legierung des zweiten Metalls und des zweiten Gettermaterials umfasst.

8. Verfahren nach einem der Ansprüche 4 bis 7, **dadurch gekennzeichnet, dass** der Schritt j) einen Schritt des Ablagerns der ersten Solubilisierungsschicht (6) auf dem ersten Substrat (1) vor dem Ablagern der ersten Metallschicht (2) aufweist und/oder dass der Schritt jj) einen Schritt des Ablagerns der zweiten Solubilisierungsschicht (8) auf dem zweiten Substrat (3) vor dem Ablagern der zweiten Metallschicht (4) aufweist.

9. Verfahren nach einem der Ansprüche 1 bis 6, **dadurch gekennzeichnet, dass** die erste Solubilisierungsschicht (6) in die erste Metallschicht (2) eingebettet ist und/oder die zweite Solubilisierungsschicht (8) in die zweite Metallschicht (4) eingebettet ist.

10. Verfahren nach einem der Ansprüche 1 bis 9, **dadurch gekennzeichnet, dass** der Schritt a) die Anwendung einer thermischen Aktivierungsbehandlung unter inerter Atmosphäre umfasst, so dass das erste Gettermaterial aktiviert wird, das die Solubilisierung von Sauerstoff gestattet und/oder dass der Schritt b) die Anwendung einer thermischen Aktivierungsbehandlung unter inerter Atmosphäre umfasst, so dass das zweite Gettermaterial aktiviert wird, das die Solubilisierung von Sauerstoff gestattet.

11. Verfahren nach einem der Ansprüche 1 bis 7, **dadurch gekennzeichnet, dass** die Anwendung der thermischen Behandlung von Schritt d) bei einer Temperatur von unter oder gleich 600 °C und vorzugsweise bei einer Temperatur von unter oder gleich 400 °C durchgeführt wird und dass die Bondingenergie zwischen der ersten Metallschicht (2) und der zweiten Metallschicht (4) einen Wert von über oder gleich 1 J/m² und vorzugsweise von über oder gleich 2 J/m² erreicht.

12. Verfahren nach einem der Ansprüche 1 bis 11, **dadurch gekennzeichnet, dass** die erste Solubilisierungsschicht (6) und/oder die zweite Solubilisierungsschicht (8) ausgelegt sind, um eine Solubilisierungsfähigkeit von Sauerstoff von über oder gleich 20 Atom-% aufzuweisen.

13. Verfahren nach einem der Ansprüche 1 bis 12 in Kombination mit Anspruch 2, **dadurch gekennzeichnet, dass** das erste und/oder das zweite Gettermaterial, die ausgelegt sind, um Sauerstoff zu solubilisieren, aus Titan, Zirconium, Palladium, Hafnium, Vanadium und den Metalllegierungen dieser Metalle ausgewählt sind.

14. Struktur (300), umfassend eine direkte Metallbondingschnittstelle für Anwendungen auf dem Gebiet der 3D-Integration, wobei die Struktur aufeinanderfolgend von ihrer Basis zu ihrer Oberfläche ein erstes Substrat (1) eines ersten Halbleitermaterials, eine erste Solubilisierungsschicht (6), die ein erstes Gettermaterial aufweist, das ausgelegt ist, um Sauerstoff zu solubilisieren, eine erste Metallschicht (2) eines ersten Metalls, die von der ersten Solubilisierungsschicht (6) verschieden ist und durch direktes Metallbonden mit einer zweiten Metallschicht (4) eines zweiten Metalls gebondet ist, die zweite Metallschicht (4), eine zweite Solubilisierungsschicht (8), die von der zweiten Metallschicht (4) verschieden ist, die ein zweites Gettermaterial aufweist, das ausgelegt ist, um Sauerstoff zu solubilisieren, und ein zweites Substrat (3) eines zweiten Halbleitermaterials aufweist.

## Claims

1. A direct metal bonding method comprising the following steps:
a) Providing a first stack (100) comprising a first substrate (1) on which is deposited a first metal layer (2) comprising a first metal, and a first solubilization layer (6) distinct from the first metal layer (2), the first solubilization layer (6) including a first getter material configured to solubilize oxygen,
b) Providing a second stack (200) comprising a second substrate (3) on which is deposited a second metal layer (4) comprising a second metal,
c) Contacting the first metal layer (2) and the second metal layer (4) so as to obtain a direct metal bonding between the first metal layer (2) and the second metal layer (4), and
d) Applying a heat treatment for annealing the bonding.
e) Application of an activation heat treatment configured to solubilize oxygen,
**characterized in that** a structure (300) comprising the first substrate (1), the first solubilization layer (6), the first metal layer (2) bonded by direct metal bonding to the second metal layer (4), and the second substrate (3) is obtained.

2. The method according to claim 1, **characterized in that** step e) is carried out at least in part by step d).

3. The method according to claim 1 or 2, **characterized in that** step e) is carried out at least in part prior to the contacting step c).

4. The method according to any of claims 1 to 3, **characterized in that** the method comprises prior to step a) a step j) consisting in depositing the first metal layer (2) according to deposition conditions promoting the presence of grain boundaries and/or **in that** the method comprises prior to step b), a step jj) consisting in depositing the second metal layer (4) according to deposition conditions promoting the presence of grain boundaries.

5. The method according to any of claims 1 to 4, **characterized in that** the method comprises prior to step a) a step j) consisting in depositing the first metal layer (2) according to a structure at least in part of the columnar type and/or **in that** the method comprises prior to step b), a step jj) consisting in depositing the second metal layer (4) according to a structure at least in part of the columnar type.

6. The method according to any of claims 1 to 5, **characterized in that** said second stack (200) further comprises a second solubilization layer (8) distinct from the second metal layer (4), the second solubilization layer (8) including a second getter material configured to solubilize oxygen.

7. The method according to any of claims 1 to 6, **characterized in that** the first solubilization layer (6) comprises an alloy of first metal and first getter material and/or in that the second solubilization layer (8) comprises an alloy of second metal and second getter material.

8. The method according to any of claims 4 to 7, **characterized in that** step j) includes a step of depositing the first solubilization layer (6) on the first substrate (1) prior to the deposition of the first metal layer (2) and/or **in that** step jj) includes a step of depositing the second solubilization layer (8) on the second substrate (3) prior to the deposition of the second metal layer (4).

9. The method according to any of claims 1 to 6, **characterized in that** the first solubilization layer (6) is buried within the first metal layer (2) and/or the second solubilization layer (8) is buried within the second metal layer (4).

10. The method according to any of claims 1 to 9, **characterized in that** step a) comprises the application of an activation heat treatment under inert atmosphere, so as to activate said first getter material for the solubilization of oxygen and/or **in that** step b) comprises the application of an activation heat treatment under inert atmosphere, so as to activate said second getter material for the solubilization of oxygen.

11. The method according to any of claims 1 to 7, **characterized in that** the application of the heat treatment of step d) is performed at a temperature lower than or equal to 600°C and preferably at a temperature lower than or equal to 400°C, and **in that** the bonding energy between the first metal layer (2) and the second metal layer (4) reaches a value greater than or equal to 1 J/m² and preferably greater than or equal to 2 J/m².

12. The method according to any of claims 1 to 11, **characterized in that** the first solubilization layer (6) and/or the second solubilization layer (8) is/are configured to have an ability to solubilize oxygen greater than or equal to 20 atomic%.

13. The method according to any of claims 1 to 12 combined with claim 2, **characterized in that** the first and/or the second getter material(s) configured to solubilize oxygen is/are selected from titanium, zirconium, palladium, hafnium, vanadium and the metal alloys of these metals.

14. A structure (300) comprising a direct metal bonding interface for applications in the field of 3D integration, the structure including, successively from its base to its surface, a first substrate (1) of a first semiconductor material, a first solubilization layer (6) including a first getter material configured to solubilize oxygen, a first metal layer (2) of a first metal, distinct from the first solubilization layer (6) and bonded by direct metal bonding to a second metal layer (4) of a second metal, the second metal layer (4), a second solubilization layer (8) distinct from the second metal layer (4), including a second getter material configured to solubilize oxygen and a second substrate (3) of a second semiconductor material.
